(19) Europäisches Patentamt
European Patent Office
Office européen des brevets

(11) EP 1 442 206 B1

(12) EUROPÄISCHE PATENTSCHRIFT

(45) Veröffentlichungstag und Bekanntmachung des Hinweises auf die Patenterteilung:
**13.04.2005 Patentblatt 2005/15**

(21) Anmeldenummer: **02782762.5**

(22) Anmeldetag: **08.11.2002**

(51) Int Cl.[7]: **F02D 41/20**, F02M 59/46, H01L 41/04

(86) Internationale Anmeldenummer:
**PCT/DE2002/004150**

(87) Internationale Veröffentlichungsnummer:
**WO 2003/040534 (15.05.2003 Gazette 2003/20)**

(54) **EINSPRITZANLAGE FÜR EINE BRENNKRAFTMASCHINE UND ZUGEHÖRIGES BETRIEBSVERFAHREN**

INTERNAL COMBUSTION ENGINE INJECTION SYSTEM AND RELATED OPERATING METHOD

SYSTEME D'INJECTION POUR MOTEUR A COMBUSTION INTERNE ET PROCEDE DE FONCTIONNEMENT ASSOCIE

(84) Benannte Vertragsstaaten:
**AT BE BG CH CY CZ DE DK EE ES FI FR GB GR IE IT LI LU MC NL PT SE SK TR**

(30) Priorität: **09.11.2001 DE 10155248**

(43) Veröffentlichungstag der Anmeldung:
**04.08.2004 Patentblatt 2004/32**

(73) Patentinhaber: **Volkswagen Mechatronic GmbH & Co.**
**09366 Stollberg (DE)**

(72) Erfinder:
- **HIRN, Rainer**
**93073 Neutraubling (DE)**
- **PIRKL, Richard**
**93047 Regensburg (DE)**

(74) Vertreter: **Beck, Josef**
**c/o Patentanwaltskanzlei Wilhelm & Beck**
**Nymphenburger Strasse 139**
**80636 München (DE)**

(56) Entgegenhaltungen:
**EP-A- 1 302 990**
**WO-A-01/14714**
**DE-A- 10 014 737**
**DE-A- 10 064 790**
**DE-A- 19 653 666**
**DE-A- 19 921 456**
**DE-A- 19 930 309**
**DE-A- 19 958 262**
**DE-A- 19 960 971**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 442 206 B1

Printed by Jouve, 75001 PARIS (FR)

## Beschreibung

Die Erfindung betrifft eine Einspritzanlage für eine Brennkraftmaschine, insbesondere für eine Pumpe-Düse-Einspritzanlage, gemäß dem Oberbegriff des Anspruchs 1 sowie ein zugehöriges Betriebsverfahren gemäß Anspruch 10, wie z.B. in dem Dokument DE 199 21 456 A gezeigt wird.

Es sind sogenannte Pumpe-Düse-Einspritzanlagen bekannt, bei denen jedem Injektor jeweils eine Hochdruckpumpe zugeordnet ist, wobei der Injektor und die Hochdruckpumpe eine sogenannte Pumpe-Düse-Einheit (PDE) bilden, die direkt in den Zylinderkopf der Brennkraftmaschine eingebaut wird. Die Hochdruckpumpe der Pumpe-Düse-Einheit kann direkt über einen Kipphebel oder indirekt über einen Stößel und einen Kipphebel von einem Einspritznocken auf der Motornockenwelle angetrieben werden. Die Steuerung des Einspritzvorgangs erfolgt hierbei durch ein magnet- oder piezogesteuertes Abflußventil, das die Hochdruckpumpe mit dem Niederdruckbereich der Einspritzanlage verbindet.

Im geschlossenen Zustand des Abflußventils kann der Kraftstoff aus der Hochdruckpumpe der Pumpe-Düse-Einheit nicht in den Niederdruckbereich entweichen und wird deshalb während des Kompressionshubs der Hochdruckpumpe in den Brennraum eingespritzt.

Ein Öffnen des Abflußventils führt dagegen zu einem Druckabfall in der Hochdruckpumpe der Pumpe-Düse-Einheit und damit zu einer Beendigung des Einspritzvorgangs. Darüber hinaus ermöglicht das Öffnen des Abflußventils auch ein Ansaugen von Kraftstoff aus dem Niederdruckbereich der Einspritzanlage für den nachfolgenden Einspritzvorgang.

Nachteilig an derartigen bekannten Pumpe-Düse-Einspritzanlagen ist die starke Geräuschentwicklung jeweils bei der Beendigung des Einspritzvorgangs.

Der Erfindung liegt somit die Aufgabe zugrunde, bei den vorstehend beschriebenen bekannten Pumpe-Düse-Einspritzanlagen die Geräuschentwicklung zu verringern bzw. ein Betriebsverfahren für derartige Pumpe-Düse-Einspritzanlagen anzugeben, das zu einer verringerten Geräuschentwicklung führt.

Die Erfindung wird, ausgehend von der eingangs beschriebenen bekannten Pumpe-Düse-Einspritzanlage gemäß dem Oberbegriff des Anspruchs 1, durch die kennzeichnenden Merkmale des Anspruchs 1 bzw. - hinsichtlich eines entsprechenden Betriebsverfahrens - durch die Merkmale des Anspruchs 10 gelöst.

Die Erfindung geht von der technischen Erkenntnis aus, dass die Geräuschentwicklung einer Pumpe-Düse-Einspritzanlage wesentlich durch den Druckstoß verursacht wird, der beim Öffnen des Abflußventils am Ende eines Einspritzvorgangs entsteht, da dann hochverdichteter Kraftstoff mit einem Druck von ca. 2.000 bar schlagartig expandiert.

Die Erfindung umfasst deshalb die allgemeine technische Lehre, das Abflußventil nicht schlagartig zu öffnen, um einen Druckstoß zu verhindern, der mit einer störenden Geräuschentwicklung verbunden ist. Vielmehr wird das Abflußventil im Rahmen der Erfindung durch eine Steuerung und/oder Regelung so geöffnet, dass sich der Kraftstoffdruck langsam abbauen kann und deshalb kaum noch zu einer störenden Geräuschentwicklung führt.

Es ist deshalb vorzugsweise ein Positionssensor vorgesehen, der die Stellung des Abflußventiles bzw. die Stellung eines das Abflußventil ansteuernden elektro-mechanischen Aktors erfasst, um ein schlagartiges Öffnen des Abflußventils erkennen und entsprechend gegenwirken zu können.

Ausgangsseitig ist der Positionssensor mit einer Steuer- bzw. Regeleinheit verbunden, die eine Treiberschaltung zur elektrischen Ansteuerung des Abflußventils bzw. des Aktors ansteuert.

Im Rahmen der Erfindung ist also vorzugsweise eine Rückkopplungsschleife vorgesehen, die eingangsseitig die Stellung des Abflußventils bzw. des zugehörigen Aktors erfasst und ausgangsseitig auf die Ansteuerung des Abflußventils bzw. des zugehörigen Aktors zurück wirkt.

In der bevorzugten Ausführungsform handelt es sich bei dem Aktor um einen piezoelektrischen Aktor, der das Abflußventil ansteuert. Anstelle eines piezoelektrischen Aktors zur Ansteuerung des Abflußventiles sind jedoch auch andere elektromechanische Aktoren einsetzbar, wie beispielsweise Magnetventile.

Bei dem Positionssensor zur Erfassung der Aktorstellung bzw. der Stellung des Abflußventils kann es sich um ein separates Bauteil beispielsweise in Form eines mechanisch-elektrischen Wandlers handeln.

In der bevorzugten Ausführungsform der Erfindung dient jedoch der zu steuernde Aktor selbst als Positionssensor. Hierbei wird die Tatsache ausgenutzt, dass ein elektro-mechanischer Wandler in einem Aktor nicht nur die Umwandlung eines elektrischen Ansteuerungssignals in eine entsprechende Stellbewegung ermöglicht, sondern auch die Erfassung eines auf diesen wirkenden Druckstoßes in Form von elektrischen Signalen erlaubt. So sind bei einem piezoelektrischen Aktor die an dem Aktor anliegende elektrische Spannung, die in dem Aktor gespeicherte elektrische Ladung sowie die auf den Aktor wirkende mechanische Kraft durch die sogenannte Piezo-Gleichung miteinander verknüpft, so dass eine Änderung der auf den Aktor wirkenden mechanischen Kraft beispielsweise bei einem Druckstoß auch zu einer Veränderung von Strom und Spannung an dem Aktor führt.

Im Rahmen der Erfindung ist deshalb vorzugsweise vorgesehen, Spannung und Strom bzw. Ladung des Aktors zu messen, um daraus die auf den Aktor wirkende Kraft bzw. die zeitliche Änderung dieser Kraft ermitteln zu können. Vorzugsweise ist hierzu eine analoge Meßschaltung vorgesehen, die ausgangsseitig den Strom durch den piezoelektrischen Aktor sowie die zeitliche Änderung der elektrischen Spannung an dem piezoelektrischen Aktor ausgibt.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:

Fig. 1 eine Schaltungsanordnung zur Ansteuerung eines Abflußventils einer erfindungsgemäßen Einspritzanlage,

Fig. 2 eine alternative Schaltungsanordnung ähnlich der in Fig. 1,

Fig. 3 ein Kraft-Zeit-Diagramm eines piezoelektrischen Aktors während eines Einspritzvorgangs sowie

Fig. 4 ein Flußdiagramm zur Erläuterung des erfindungsgemäßen Betriebsverfahrens.

Die in den Figuren 1 und 2 dargestellten Schaltungsanordnungen dienen zur Ansteuerung eines piezoelektrischen Aktors 1, der in einer Pumpe-Düse-Einheit (PDE) einer Pumpe-Düse-Einspritzanlage für eine Brennkraftmaschine das Abflußventil ansteuert.

Derartige Pumpe-Düse-Einheiten sind beispielsweise aus dem kraftfahrttechnischen Handbuch der Firma Bosch (ISBN 3-18-419122-2), 22. Auflage, Seite 519 - 520 bekannt, so dass im folgenden auf eine detaillierte Beschreibung von Pumpe-Düse-Einheiten verzichtet werden kann und diesbezüglich auf die vorstehend erwähnte Veröffentlichung verwiesen wird.

Weiterhin ist zu erwähnen, dass die in den Figuren 1 und 2 dargestellten Schaltungsanordnungen in gleicher Weise zur Ansteuerung eines Aktors für ein Abflußventil einer Pumpe-Leitung-Düse-Einspritzanlage verwendet werden kann, die ebenfalls in der vorstehend erwähnten Veröffentlichung beschrieben wird.

In jedem Fall ermöglicht der Aktor 1 eine Steuerung des Abflußventils und damit eine Steuerung des Einspritzvorgangs. Im geöffneten Zustand des Abflußventils kann die Hochdruckpumpe der Pumpe-Düse-Einheit bzw. der Pumpe-Leitungs-Düse-Einheit Kraftstoff aus dem Niederdruckbereich der Einspritzanlage ansaugen. Im geschlossenen Zustand des Abflußventils kann der Kraftstoff dagegen nicht in den Niederdruckbereich der Einspritzanlage zurückfließen und wird deshalb während des Kompressionshubs der Hochdruckpumpe komprimiert und schließlich in den Brennraum der Brennkraftmaschine eingespritzt. Beim Öffnen des Abflußventils der Einspritzanlage bricht der Kraftstoffdruck dann zusammen, wodurch der Einspritzvorgang beendet wird.

Die Ansteuerung des Aktors 1 des Abflußventils erfolgt durch eine elektrische Treiberschaltung 2, die hier nur schematisch dargestellt ist.

Zur Messung des durch den Aktor 1 fließenden elektrischen Stroms ist der Aktor 1 mit einem Meßwiderstand 3 mit einer Größenordnung von wenigen mΩ in Reihe geschaltet. Zwischen dem Aktor 1 und dem Meßwiderstand 3 ist ein Spannungsabgriff vorgesehen, der mit einem Verstärker 4 verbunden ist, so dass am Ausgang des Verstärkers 4 ein elektrisches Signal erscheint, das den durch den Aktor 1 fließenden elektrischen Strom wiedergibt.

Parallel zu der Reihenschaltung aus dem Aktor 1 und dem Meßwiderstand 3 ist eine Reihenschaltung aus einem Kondensator 5 und zwei Widerständen 6, 7 angeordnet, um die zeitliche Änderung der über dem Aktor 1 abfallenden Spannung zu erfassen. Zwischen dem Widerstand 6 und dem Widerstand 7 ist deshalb ein Spannungsabgriff vorgesehen, an dem ein elektrisches Signal anliegt, das die zeitliche Änderung der elektrischen Spannung über dem Aktor 1 wiedergibt.

Weiterhin ist eine Recheneinheit 8 vorgesehen, die eingangsseitig zum einen mit dem Verstärker 4 und zum anderen mit dem Spannungsabgriff zwischen den beiden Widerständen 6 und 7 verbunden ist. Die Recheneinheit 8 berechnet aus dem Strom I, der Spannung U und zwei Konstanten c1 und $c_2$ nach der bekannten Piezo-Gleichung

$$\frac{dF}{dt} = \frac{1}{c_1} \cdot \left( \frac{dU}{dt} - \frac{I(t)}{c_2} \right)$$

die zeitliche Änderung dF/dt der auf den Aktor 1 wirkenden mechanischen Kraft F, um bei einem Öffnen des Abflußventiles am Ende eines Einspritzvorgangs einen plötzlich auftretenden Druckstoß erkennen zu können.

Ausgangsseitig ist die Recheneinheit 8 mit einer Regeleinheit 9 verbunden, die in Abhängigkeit von der zeitlichen Änderung der auf den Aktor 1 wirkenden mechanischen Kraft den Sollwert $U_{SOLL}$ für die elektrische Spannung bestimmt, mit der der Aktor 1 zu beaufschlagen ist. Der Regler 9 arbeitet hierbei so, dass der Öffnungsvorgang des Abflußventils verlangsamt wird, wenn die auf den Aktor 1 wirkende mechanische Kraft aufgrund eines plötzlichen Druckstoßes zu groß wird. So zeigt Figur 3 ein Kraft-Zeit-Diagramm der auf den Aktor 1 wirkenden mechanischen Kraft, wobei das Abflußventil zum Zeitpunkt $t_1$ geöffnet wird. Zum Zeitpunkt $t_2$ beginnt dann der Druckstoß, wobei die Kurve 10 den idealen Soll-Druckstoßverlauf zeigt. Die Kurve 11 gibt dagegen einen zu großen Druckstoß an, der zu einer unerwünschten Geräuschentwicklung führt, während die Kurve 12 einen zu geringen Druckstoß zeigt, was mit unerwünschten Schadstoffemissionen verbunden ist. Die Regeleinheit 9 regelt den Sollwert $U_{SOLL}$ für die Aktorspannung deshalb so, dass die Aktorkraft der Kurve 10 folgt.

Figur 2 zeigt ein alternatives Ausführungsbeispiel, das weitgehend mit dem in Figur 1 dargestellten Ausführungsbeispiel übereinstimmt, so dass im folgenden dieselben Bezugszeichen verwendet werden und zur Vermeidung von Wiederholungen auf die vorstehende Beschreibung zu Figur 1 verwiesen wird.

Eine Besonderheit des Ausführungsbeispiels gemäß Figur 2 besteht darin, dass der Spannungsabgriff zwischen den beiden Widerständen 6 und 7 über einen Kondensator 13 und einen Widerstand 14 mit dem Ausgang des Verstärkers 4 verbunden ist. Weiterhin ist die Recheneinheit 8 eingangsseitig mit den beiden Anschlüssen des Widerstands 14 verbunden und erfasst die Spannung über dem Widerstand 14, die die zweite zeitliche Ableitung der auf den Aktor 1 wirkenden mechanischen Kraft wiedergibt.

Die Regeleinheit 9 weist einen entsprechend angepassten Regelalgorithmus auf, um den Sollwert $U_{SOLL}$ für die Aktorspannung so zu regeln, dass die auf den Aktor 1 wirkende mechanische Kraft dem vorgegebenen Kurvenverlauf 10 folgt.

Im folgenden wird nun anhand des in Figur 4 dargestellten Flußdiagramms der Ablauf des erfindungsgemäßen Betriebsverfahrens beschrieben.

So wird der Aktor zum Öffnen des Ventils mit einem vorgegebenen Spannungssignal beaufschlagt. Während des Öffnungsvorgangs des Abflußventils wird der Aktorstrom und die zeitliche Änderung der Aktorspannung gemessen, um daraus gemäß der vorstehend erwähnten bekannten Piezo-Gleichung die zeitliche Änderung der Aktorkraft zu berechnen. Die Aktorspannung wird dann in Abhängigkeit von der zeitlichen Änderung der Aktorkraft so geregelt, dass die Aktorkraft während eines Absteuervorgangs der Kurve 10 in Figur 3 folgt.

Die Erfindung ist nicht auf die vorstehend beschriebenen bevorzugten Ausführungsbeispiele beschränkt.

Bezugszeichenliste

| | |
|---|---|
| 1 | Aktor |
| 2 | Treiberschaltung |
| 3 | Meßwiderstand |
| 4 | Verstärker |
| 5 | Kondensator |
| 6,7 | Widerstände |
| 8 | Recheneinheit |
| 9 | Regeleinheit |
| 10 | Soll-Druckstoßverlauf |
| 11 | zu großer Druckstoß |
| 12 | zu kleiner Druckstoß |
| 13 | Kondensator |
| 14 | Widerstand |

**Patentansprüche**

**1.** Einspritzanlage für eine Brennkraftmaschine, insbesondere für eine Pumpe-Düse-Einspritzanlage, mit
mindestens einem Injektor mit einem elektro-mechanischen Aktor (1) zur Steuerung des Einspritzvorgangs,
einer Treiberschaltung (2) zur elektrischen Ansteuerung des Aktors (1),
einer Steuer- oder Regeleinheit (9), die eingangsseitig mit einem die Aktorstellung erfassenden Positionssensor (1) und ausgangsseitig mit der Treiberschaltung (2) verbunden ist, wobei die Steuer- bzw. Regeleinheit (9) über eine analoge Meßschaltung (3-7) mit dem Aktor (1) verbunden ist,
**dadurch gekennzeichnet,**
**dass** die Meßschaltung (3-7) einen ersten Meßwiderstand (3) aufweist, der mit dem Aktor (1) in Reihe geschaltet ist, wobei zwischen dem ersten Meßwiderstand (3) und dem Aktor (1) ein erster Spannungsabgriff vorgesehen ist, der mit der Steuer- bzw. Regeleinheit (9) verbunden ist,
**dass** dem Aktor (1) eine Reihenschaltung aus einem ersten Kondensator (5) und einem zweiten Meßwiderstand (7) parallel geschaltet ist, wobei zwischen dem zweiten Meßwiderstand (7) und dem Kondensator (5) ein zweiter Spannungsabgriff vorgesehen ist, der mit der Steuer- bzw. Regeleinheit (9) verbunden ist,
**dass** die beiden Spannungsabgriffe in der Meßschaltung (3-7) über eine Reihenschaltung aus einem Widerstand (14) und einem zweiten Kondensator (13) miteinander verbunden sind.

**2.** Einspritzanlage nach Anspruch 1,
**dadurch gekennzeichnet,**
**dass** der Positionssensor der Aktor (1) selbst ist.

**3.** Einspritzanlage nach Anspruch 1 oder 2,
**dadurch gekennzeichnet,**
**dass** der Aktor (1) ein piezoelektrischer Aktor (1) ist.

**4.** Einspritzanlage nach Anspruch 1,
**gekennzeichnet durch**
eine Recheneinheit (8) zur Berechnung der zeitlichen Änderung der Aktorkraft in Abhängigkeit von den Signalen an den beiden Spannungsabgriffen der Meßschaltung (3-7) vorgesehen ist.

**5.** Einspritzanlage nach einem der Ansprüche 1 bis 4;
**gekennzeichnet durch**
eine Recheneinheit (8) zur Berechnung der zweiten zeitlichen Ableitung der Aktorkraft aus den Signalen an den beiden Spannungsabgriffen der Meßschaltung (3-7).

6. Verfahren zum Betrieb einer Einspritzanlage nach Anspruch 1, insbesondere einer Pumpe-Düse-Einspritzanlage, mit den folgenden Schritten:

   - Elektrische Ansteuerung eines Aktors (1) zum Öffnen eines Ventils,
   - Messung der Aktorstellung und/oder der Aktorkraft während der Ventilöffnung,
   - Beeinflussung der elektrischen Ansteuerung in Abhängigkeit von der gemessenen Aktorstellung und/oder der Aktorkraft.

7. Verfahren nach Anspruch 6,
   **dadurch gekennzeichnet,**
   **dass** die elektrische Ansteuerung des Aktors (1) in Abhängigkeit von der gemessenen Aktorstellung und/oder der Aktorkraft geregelt wird.

8. Verfahren nach Anspruch 6 oder 7,
   **dadurch gekennzeichnet,**
   **dass** der Öffnungsvorgang des Ventils durch eine entsprechende elektrische Ansteuerung verlangsamt wird, wenn die Messung der Aktorstellung und/oder der Aktorkraft einen Druckstoß auf den Aktor (1) anzeigt.

## Claims

1. Injection system for an internal combustion engine, in particular for a pump nozzle injection system, having
   at least one injector with an electromechanical actuator (1) for controlling the injection process,
   a driver circuit (2) for electrically activating the actuator (1)
   a control or regulating unit (9), which is connected on the input side to a position sensor (1) recording the position of the actuator, and on the output side to the driver circuit (2), whereby the control and/or regulating unit (9) is connected to the actuator (1) by means of an analogue measurement circuit (3-7),
   **characterised in that**
   the measurement circuit (3-7) comprises a first measurement resistor (3), which is connected in series to the actuator (1), whereby a first voltage pick-off is provided between the first measurement resistor (3) and the actuator (1), said voltage pick-off being connected to the control and/or regulating unit (9),
   a series circuit comprising a first capacitor (5) and a second measurement resistor (7) is connected in parallel to the actuator (1), whereby a second voltage pick-off is provided between the second measurement resistor (7) and the capacitor (5), said voltage pick-off being connected to the control and/or regulating unit (9), the two voltage pick-offs are connected to one another in the measurement circuit (3-7) by means of a series circuit comprising a resistor (14) and a second capacitor (13).

2. Injection system according to Claim 1,
   **characterised in that**
   the position sensor is the actuator (1) itself.

3. Injection system according to Claim 1 or 2,
   **characterised in that**
   the actuator (1) is a piezoelectric actuator (1)

4. Injection system according to Claim 1,
   **characterised in that**
   a computing unit (8) for calculating the temporal change in the actuator force is provided as a function of the signals at the two voltage pick-offs of the measurement circuit (3-7).

5. Injection system according to one of the Claims 1 to 4
   **characterised by**
   a computing unit (8) for calculating the second temporal derivation of the actuator force from the signals at the two voltage pick-offs of the measurement circuit (3-7).

6. Method for operating an injection system according to Claim 1, in particular a pump nozzle injection system, comprising the following steps;

   - electrical activation of an actuator (1) for opening a valve,
   - measurement of the actuator position and/or the actuator force during the valve opening
   - influencing the electrical activation as a function of the measured actuator position and/or the actuator force

7. Method according to Claim 6,
   **characterised in that**
   the electrical activation of the actuator (1) is regulated as a function of the measured actuator position and/or the actuator force.

8. Method according to Claim 6 or 7
   **characterised in that**
   the opening process of the valve is decelerated by means of a corresponding electrical activation, if the measurement of the actuator position and/or the actuator force indicates a pressure surge to the actuator (1).

## Revendications

1. Système d'injection pour moteur à combustion interne, notamment pour système d'injection à pompe et buse, comprenant :

au moins un injecteur comportant un actionneur électromécanique (1) servant à commander le processus d'injection,
un circuit d'attaque (2) servant à exciter électriquement l'actionneur (1),
une unité de commande ou de réglage (9) qui est reliée, côté entrée, à un capteur de position détectant la position de l'actionneur (1) et, côté sortie, au circuit d'attaque (2), l'unité de commande ou de réglage (9) étant reliée à l'actionneur (1) par l'intermédiaire d'un circuit de mesure analogique (3 à 7) ;

**caractérisé en ce que** :

le circuit de mesure (3 à 7) comporte une première résistance de mesure (3) qui est montée en série avec l'actionneur (1), un premier dispositif de prise de tension relié à l'unité de commande ou de réglage (9) étant prévu entre la première résistance de mesure (3) et l'actionneur (1),
un montage en série constitué d'un premier condensateur (5) et d'une deuxième résistance de mesure (7) est monté en parallèle à l'actionneur (1), un deuxième dispositif de prise de tension relié à l'unité de commande ou de réglage (9) étant prévu entre la deuxième résistance de mesure (7) et le condensateur (5),
les deux dispositifs de prise de tension faisant partie du circuit de mesure (3 à 7) sont reliés ensemble par l'intermédiaire d'un montage en série constitué d'une résistance (14) et d'un deuxième condensateur (13).

**2.** Système d'injection selon la revendication 1,
**caractérisé en ce que** le capteur de position est l'actionneur (1) lui-même.

**3.** Système d'injection selon la revendication 1 ou 2,
**caractérisé en ce que** l'actionneur (1) est un actionneur piézoélectrique (1).

**4.** Système d'injection selon la revendication 1,
**caractérisé par** une unité de calcul (8) servant à calculer la modification temporelle de la force de l'actionneur en fonction des signaux présents au niveau des deux dispositifs de prise de tension du circuit de mesure (3 à 7).

**5.** Système d'injection selon au moins l'une des revendications 1 à 4,
**caractérisé par** une unité de calcul (8) servant à calculer la deuxième dérivée temporelle de la force de l'actionneur à partir des signaux présents au niveau des deux dispositifs de prise de tension du circuit de mesure (3 à 7).

**6.** Procédé de mise en oeuvre d'un système d'injection selon la revendication 1, notamment d'un système d'injection à pompe et buse, comprenant les étapes suivantes :

- excitation électrique d'un actionneur (1) servant à ouvrir une soupape,
- mesurage de la position de l'actionneur et/ou de la force de l'actionneur pendant l'ouverture de la soupape,
- action sur l'excitation électrique en fonction de la position et/ou de la force mesurées de l'actionneur.

**7.** Procédé selon la revendication 6,
**caractérisé en ce que** l'excitation électrique de l'actionneur (1) est réglée en fonction de la position et/ou de la force mesurées de l'actionneur.

**8.** Procédé selon la revendication 6 ou 7,
**caractérisé en ce que** le processus d'ouverture de la soupape est ralenti à l'aide d'une excitation électrique appropriée lorsque le mesurage de la position et/ou de la force de l'actionneur indique un coup de bélier sur l'actionneur (1).

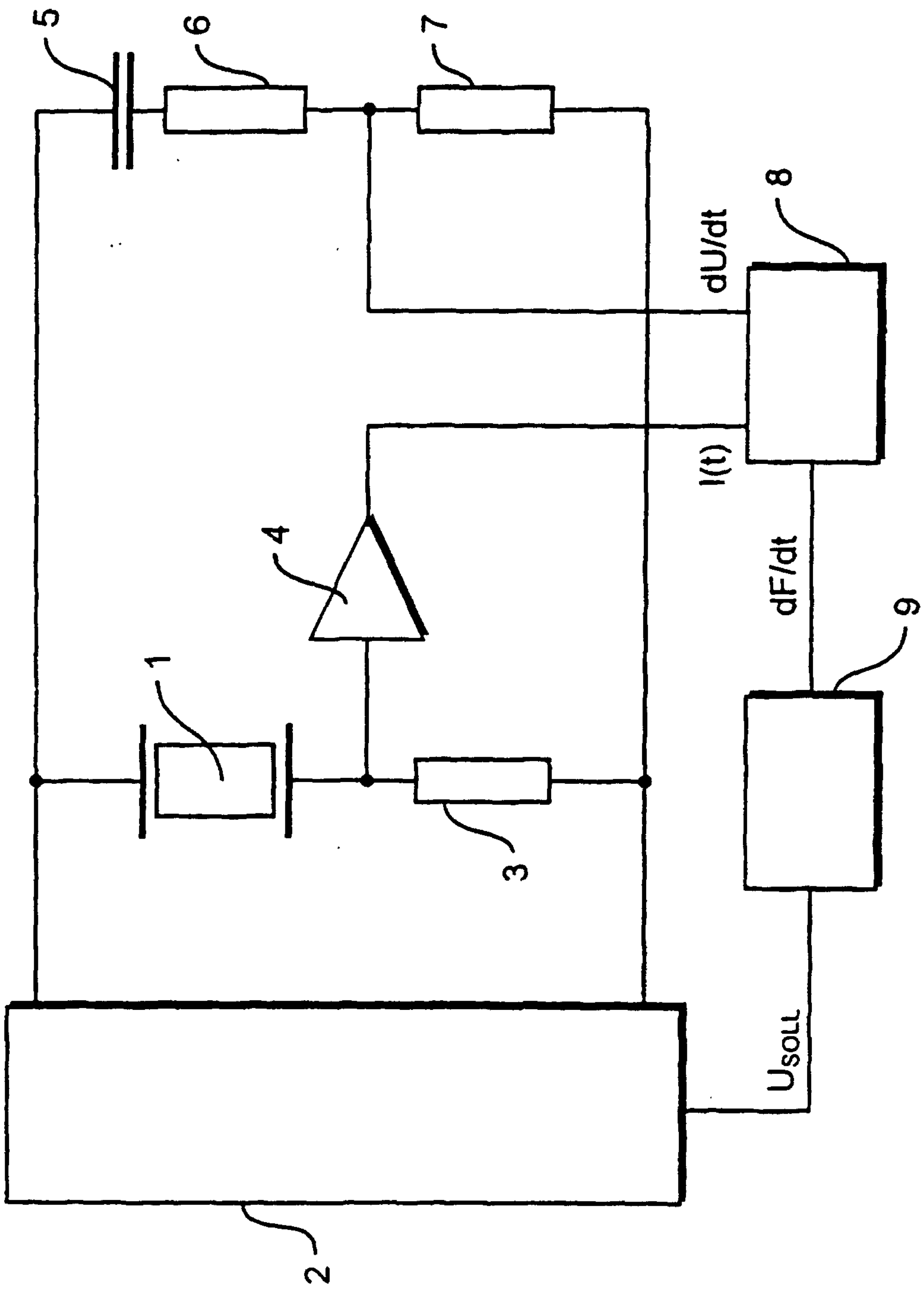


Fig. 1

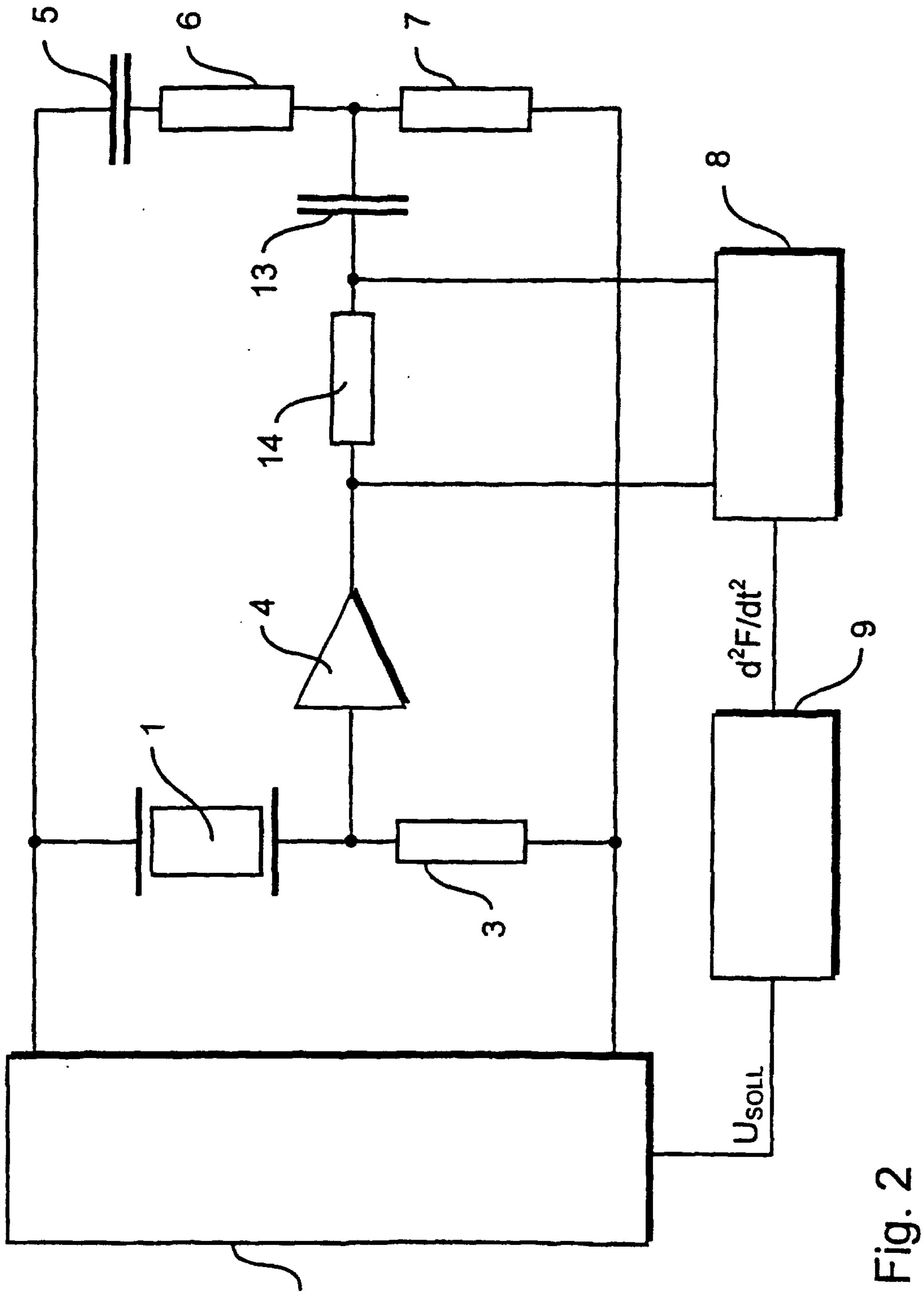


Fig. 2

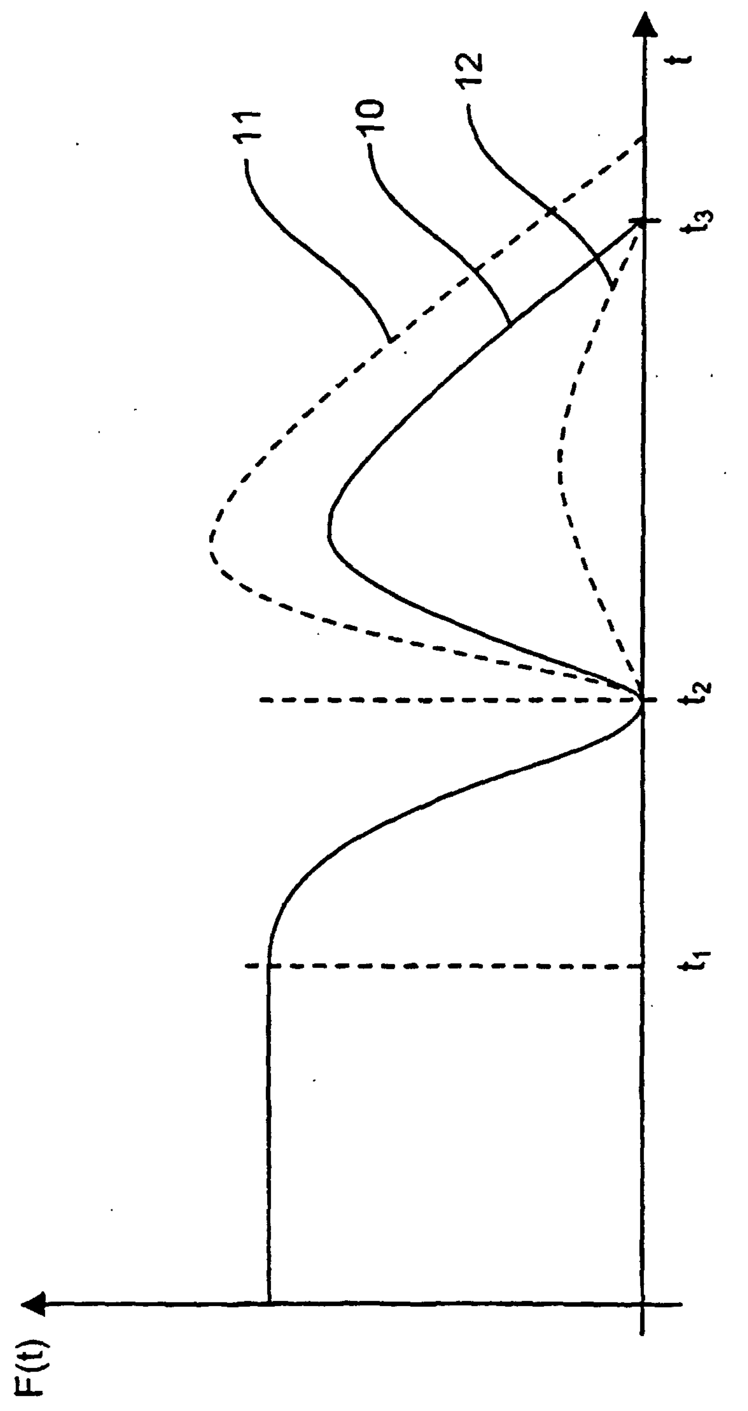


Fig. 3

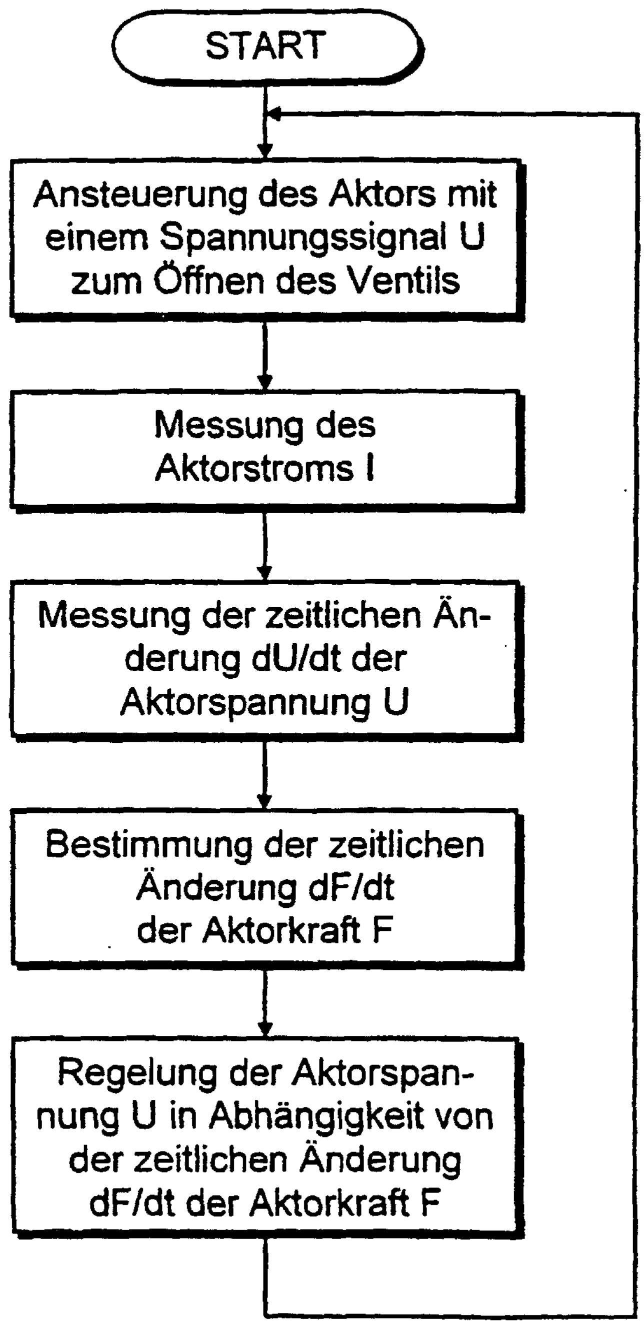
START
Ansteuerung des Aktors mit einem Spannungssignal U zum Öffnen des Ventils
Messung des Aktorstroms I
Messung der zeitlichen Änderung dU/dt der Aktorspannung U
Bestimmung der zeitlichen Änderung dF/dt der Aktorkraft F
Regelung der Aktorspannung U in Abhängigkeit von der zeitlichen Änderung dF/dt der Aktorkraft F

Fig. 4